(19) Europäisches Patentamt
European Patent Office
Office européen des brevets

(11) **EP 4 390 539 A1**

(12) **EUROPEAN PATENT APPLICATION**

(43) Date of publication:
**26.06.2024 Bulletin 2024/26**

(21) Application number: **22214517.9**

(22) Date of filing: **19.12.2022**

(51) International Patent Classification (IPC):
*G03F 7/00* *(2006.01)*

(52) Cooperative Patent Classification (CPC):
**G03F 7/0002**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventors:
- **VERSCHUUREN, Marcus Antonius**
  **5656 AG Eindhoven (NL)**
- **ARLT, Christian Alfred**
  **5656 AG Eindhoven (NL)**

(74) Representative: **Philips Intellectual Property & Standards**
**High Tech Campus 52**
**5656 AG Eindhoven (NL)**

(54) **ALIGNMENT METHOD FOR IMPRINT METHOD**

(57) A method of detecting a detection angle in a lithographic apparatus, the method comprising using a calibration substrate having a refractive index n and having a first pair of markers, the pair of markers having a predetermined lateral displacement from each other, the first marker in the pair of markers being at a first predetermined vertical position within the calibration substrate and the second marker in the pair of markers being at a second predetermined vertical position within the calibration substrate, the calibration substrate resting on its first surface, illuminating the pair of markers by a light source, detecting, by a detector having an optical axis, light redirected from the first marker and the second marker to determine a first detected lateral displacement between the first marker and the second marker, wherein the optical axis of the detector is at a detection angle, $\alpha_1$, relative to the normal of the substrate of less than 90° and determining the first detection angle based on the first detected lateral displacement between the first and second marker.

200

Load a calibration substrate — 210

↓

Illuminate pair of markers — 220

↓

Detect redirected light — 230

↓

Determine first detected angle of illumination — 240

FIG. 3

EP 4 390 539 A1

## Description

### FIELD OF THE INVENTION

The present invention relates to the field of alignment in imprint lithography, particularly in flexible stamp imprint lithography.

### BACKGROUND OF THE INVENTION

Imprint lithography, of the type disclosed in EP 3126909A, is gaining interest as a viable alternative to more traditional mask-based optical lithography techniques, as imprint lithography promises to be able to provide small(ler) feature sizes in a pattern to be transferred onto a substrate such as the substrate of a semiconductor device over a large area. In imprint lithography techniques such as substrate conformal imprinting lithography ("SCIL"), a flexible stamp including a feature relief pattern on its surface is brought into contact with carrying a resist material. The resist material is imprinted by the feature pattern and subsequently developed, e.g. cured, while being imprinted. Thereafter the feature pattern is released from the resist material to leave a patterned resist layer on the substrate.

In this process, a curable but fluid resist layer is applied to the substrate (e.g. a wafer) supported on a chuck. The flexible stamp is for example rubber and resist layer may be cured (solidified) while being imprinted to leave the solidified relief in the resist layer which is complementary to that of the stamp relief layer after removal of the stamp from the resist. The imprint process entails arranging the thin flexible stamp, for example formed of a polydimethylsiloxane ("PDMS") rubber layer adhered to a thin flexible plate such as e.g. a metal plate or glass plate with the relief surface of the PDMS layer opposing the glass plate side, onto a stamp manipulator. This provides that the glass plate is against the stamp manipulator and the stamp's relief surface opposes the resist layer.

### SUMMARY OF THE INVENTION

During the imprinting process, the stamp and resist layer surface of the substrate are held substantially parallel to each other in the X-Y plane and at a small mutual distance along the Z-axis direction.

The stamp may be locally manipulated using the stamp manipulator, for example it may be locally and sequentially released from and adhered to the stamp manipulator by the stamp manipulator. In one example the stamp manipulator has openings, extending along the surface (X-Y plane) of the stamp manipulator that can be individually operated at set pressures such as over- or underpressure so as to either hold the stamp (underpressure) or release the stamp (overpressure). During the imprint process, by releasing the stamp at one X-Y location (e.g., at an edge), a first contact is made between the relief surface and resist at that location. The stamp is then gradually released from the stamp manipulator to be brought in contact withthe resist layer. The contact thereby grows from the first contact location along the X- and/or Y-axis direction depending on the release scheme.

Alignment between the stamp and the substrate uses markers on each of the stamp and the substrate. The markers on each of the stamp and the substrate are illuminated and the redirected light is detected to determine the locations of the markers(absolute or relative and with respect to eachother) h. The location of the stamp can then be compared with the location of the substrate to check that they are correctly aligned. If they are not correctly aligned the stamp and/or substrate should be moved accordingly.

The inventors have realised that because imprint lithography relies on contact of stamp and substrate and alignment mismatch is difficult to correct after first contact has been established, the alignment must occur before imprinting begins. This however caues that the alginment must be done at a time a relatively large gap (i.e. the distance along the Z-axis direction) between the stamp and the substrate exists and this complicates alignment. For example, if the light used for illumination is not perpendicular, the relatively large gap will cause a parallax error and the measured locations of markers will be incorrect. Or if the camera if not perpendicular to the stamp / wafer surface this will also induce a parallax error.

There is thus a need to improve alignment for an imprinting procedure to reduce or remove this misalignment issue even when there exists the relatively large gap.

Another issue is to avoid problems resulting from non-perpendicular illumination of the substrate.

Some implementations may use non-perpendicular illumination of the substrate and in these situations it is important to know the exact detection angle. Another issue is the need to avoid problems resulting from illumination of the substrate at an incorrect angle.

The invention aims to address one or more of these issues.

According to the current disclosure there is provided a method of determining a detection angle in a lithographic apparatus, the method comprising:

using a calibration substrate having a refractive index n and having a first pair of markers, the pair of markers having a predetermined lateral displacement from each other, the first marker in the pair of markers being at a first predetermined vertical position within the calibration substrate and the second marker in the pair of markers being at a second predetermined vertical position within the calibration substrate, the calibration substrate resting on its first surface;
illuminating the pair of markers by a light source;
detecting, by a detector having an optical axis, light redirected from the first marker and the second marker to determine a first detected lateral displacement between the first marker and the second marker, wherein the optical axis of the detector is at a detection angle, $\alpha_1$, relative to the normal of the substrate of less than 90°; and
determining the first detection angle based on the first detected lateral displacement between the first and second marker.

By detecting the detection angle the parallax error due to the detection angle, and gap between the stamp and substrate can be determined and therefore accounted for. For example, from a known gap with a known parallax error a displacement in the x direction and the y direction can be calculated.

The detection angle can be determined so that the parallax error can be calculated and compensated for during imprinting in multiple ways. Thus, the detection angle does not need to be corrected to be perpendicular to the substrate but, by knowing the detection angle, the parallax error can be calculated and compensated for in subsequent calculations and alignment steps. Additionally, by determining the detection angle the parallax error due to substrates made from materials with different refractive indices may be calculated and compensated.

So, rather than trying to reduce, or eliminate the parallax, as in earlier systems and methods, the present invention has a non-perpendicular detection so that the parallax can be calculated. In summary, the detection in the present invention is non-perpendicular and uses the consequential parallax to determine the angle of detection.

In some implementations a desired, non-perpendicular, angle of detection can be required and in these implementations angle of detection can be calculated and the angle of detection changed or corrected to the desired angle.

The present invention can be used firstly to determine the camera tilt, or detection angle, but also to ensure that the camera angle is stable over time by repeating the measurement(s) at a later time.

The invention may be used in imprinting lithographic apparatus, in particular substrate conformal imprinting lithographic apparatus, in which alignment between the substrate and stamp must be completed prior to the imprinting.

The method may further comprise:

turning the calibration substrate to rest on its second, different, surface;
illuminating the pair of markers by the light source;
detecting light redirected from the first marker and the second marker to determine a second detected lateral displacement between the first marker and the second marker;
determining a second detection angle, $\alpha_2$, based on the second detected lateral displacement between the first and second marker.

By turning the calibration substrate onto its second surface the same pair of markers can again be detected and measured. An average of the first detection angle and the second detection angle can be taken. As the calibration substrate is turned upside down any errors in the predetermined lateral displacement will be reversed.

The markers may be contrast markers configured to reflect light or diffractive markers configured to diffract light.

The lateral (i.e. in an X-Y plane) displacement between the first and second markers may be zero. Alternatively, the lateral displacement may be a minimal amount so that both the first and second markers can be illuminated simultaneously without one marker inhibiting light from reaching the other marker.

The first detection angle, $\alpha_1$ may be given by:

$$\alpha_1 = \sin^{-1}\frac{n * (X_1 - LD)}{D_W}$$

where $X_1$ is the measured displacement, LD is the lateral displacement and Dw is the vertical distance between the first marker and the second marker.

The detection angle, $\alpha_2$ may be given by:

$$\alpha_2 = \sin^{-1}\frac{n * (X_2 - LD)}{D_W}$$

where $X_2$ is the measured displacement, LD is the lateral displacement and Dw is the vertical distance between the first marker and the second marker.

The method may further comprise:

providing a stamp comprising a stamp marker;
illuminating the stamp marker using the light source;
detecting the light from the light source redirected by the stamp marker;
determining the lateral position of the stamp marker using at least the first detection angle.

Similar to the detection of the stamp marker a substrate marker may be detected and the method further comprise:

providing a second substrate comprising a substrate marker;
illuminating the substrate marker using the light source;
detecting the light from the light source redirected by the substrate marker;
determining the lateral position of the substrate marker using at least the first detection angle.

Once the position of the stamp marker and the substrate marker have been determined the degree of alignment can be determined. Advantageously, this method allows for an improved degree of accuracy in detecting alignment.

An alternative implementation envisages the light source maintaining a fixed detection angle relative to a substrate, or substrate surface. Using the present invention the detection angle can be determined and, if it is not within a predetermined range, the light source moved to a different detection angle.

According to the invention there is provided an alignment system for determining an alignment between a stamp and a substrate in a substrate conformal imprint lithography process, wherein the alignment system comprises:

a light source;
a light sensor having an optical axis and configured to detect light from the light source redirected by the substrate wherein the optical axis of the light sensor is at a detection angle $\alpha_1$, relative to the normal of the substrate of less than 90 °;
a processing system communicatively coupled to the light source and light sensor and configured to determine a first detection angle, $\alpha_1$, based on the first detected lateral displacement between the first and second marker on a calibration substrate.

The alignment system may comprise a calibration substrate, the calibration substrate having a refractive index n and a first pair of markers, the pair of markers having a predetermined lateral displacement from each other, the first marker in the pair of markers being at a first predetermined vertical position within the calibration substrate and the second marker in the pair of markers being at a second predetermined vertical position within the calibration substrate having a first marker.

The processing system may be further configured to control the alignment system to carry out the following steps:

illuminate a pair of markers by the light source;
detect light redirected from a first marker and a second marker to determine a first detected lateral displacement between the first marker and the second marker.

A computer program product comprising computer program code means which, when executed by the alignment system as described above, causes the alignment system to perform all of the steps of the method described above.

The invention relates to the alignment of markers in a SCIL process, in particular when the detector is arranged substantially perpendicularly to the substrate. This arrangement has the disadvantage that signals from a substrate marker and a stamp marker may become mixed and indistinguishable.

The processing system of the alignment system may be configured to control the operation of the lighting system and/or the light sensor to control the alignment system in performing the defined functions.

According to an example of the invention there is provided a computer program product comprising computer program code means which, when executed by the alignment system of as described above, causes the alignment system to perform all of the steps of the method as described above.

These and other aspects of the invention will be apparent from and elucidated with reference to the embodiment(s) described hereinafter.

BRIEF DESCRIPTION OF THE DRAWINGS

For a better understanding of the invention, and to show more clearly how it may be carried into effect, reference will now be made, by way of example only, to the accompanying drawings, in which:

Figs. 1A, 1B and 1C show cross sectional views of an imprinting process;
Fig. 2A depicts a calibration substrate;
Fig. 2B depicts and alternative calibration substrate;

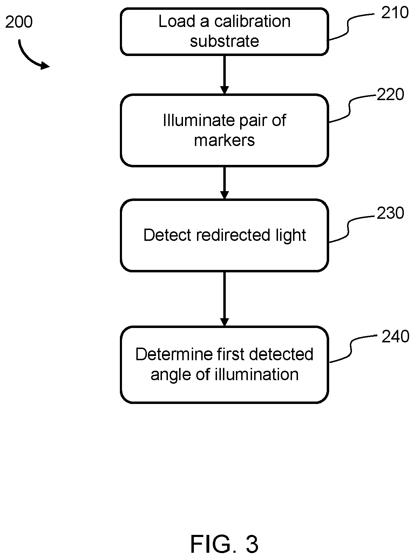

Fig. 3 depicts the method of the invention;
Fig. 4 depicts the illumination of a pair of markers;
Fig. 5 is an enlarged depiction of the incident light on the first marker; and

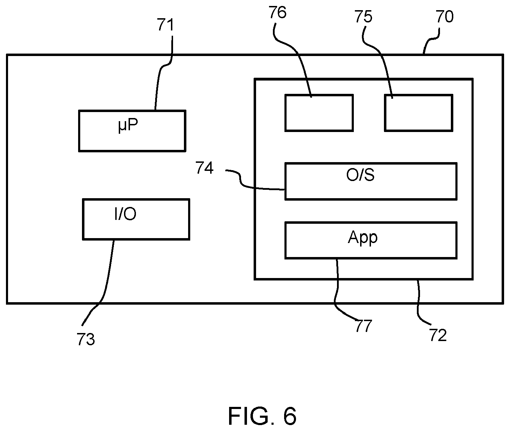

Fig. 6 is a simplified block diagram of a computer within which one or more parts of an embodiment may be employed.

DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. The mere fact that certain measures are recited in mutually different dependent claims does not indicate that a combination of these measures cannot be used to advantage.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

The Figures are merely schematic and are not drawn to scale. The same reference numerals are used throughout the Figures to indicate the same or similar parts.

Embodiments propose a mechanism for aligning a stamp and a substrate during an imprint process such as e.g. a substrate conformal imprint lithography ("SCIL") process. A stamp marker is positioned on the stamp and a substrate marker is positioned on the substrate. The markers may comprise diffraction gratings but may also comprise other types of marker. The two markers may be illuminated by the same or two different lights. Each marker is configured to redirect proportionally more of one form of light (received by said marker) towards a light sensor than the other marker.

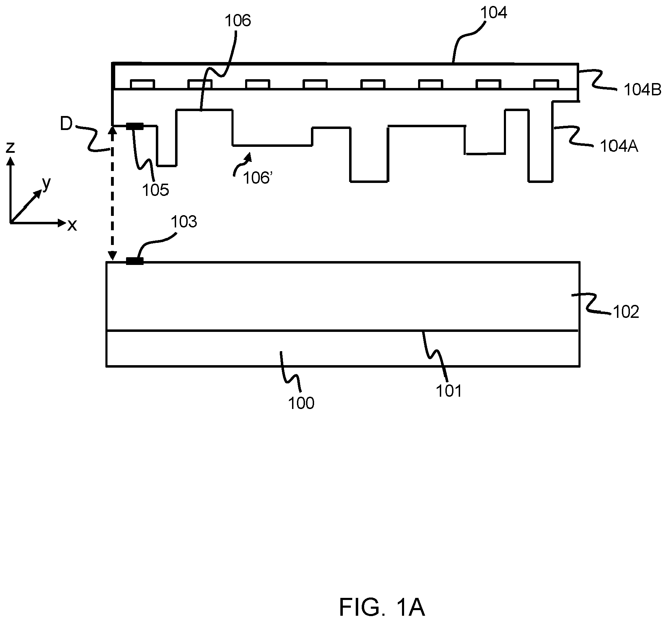

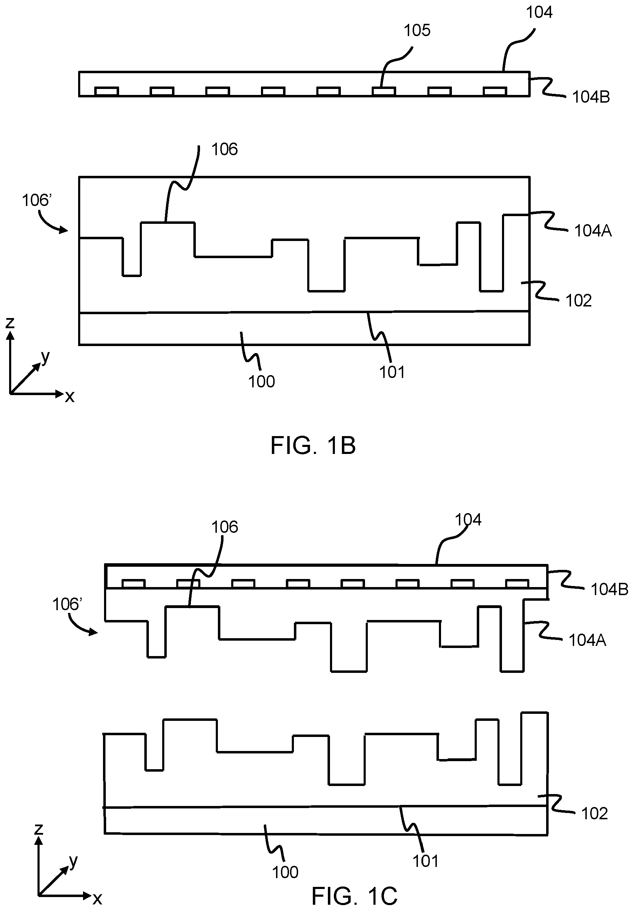

Figs. 1A, 1B and 1C illustrate a fabrication process for the purposes of improved contextual understanding.

Known processes for fabrication of microdevices comprise successive application of device layers to a substrate. A typical process cycle for applying such a device layer comprises deposition of a layer of desired material, for example, an insulator or (semi)conductor, followed by structuring, or so called patterning of the applied layer.

In the present disclosure, the structuring of the material layer is done using an imprinting or embossing method. This process includes (during a cycle of steps) a procedure of applying a material layer 102 to a surface 101 of a substrate 100, for example, by way of droplets using inkjet printing, or uniformly dispersal using spincoating or a doctor blade technique over the substrate surface 101. Any other application technique may be used as well. The applied material layer 102 is formable.

A stamp 104 having a relief surface 106 representing a pattern 106' that needs to be replicated in or imaged into the material layer 102 is positioned above the substrate 104 at a distance D between a substrate marker 103 and a stamp marker 105, as shown in Fig 1A. Once the stamp 104 and the substrate 100 are correctly aligned the material layer 102 of the stamp is brought into contact with the stamp so that the stamp imprints the shape of the relief surface onto the material layer 102, as depicted in Fig 1B.

During the time in which the stamp 104 is in contact with the material layer 102 (as depicted in Fig. 1B), the material layer first adopts (e.g. conforms to) the shape of the relief surface 106 of the pattern 106' and then is hardened beyond (re)formability using some curing process. Example curing processes use chemical reactions to solidify the layers under application of heat or radiation, or by solvent removal from the layer as described in the European Patent Applications having publication numbers EP 2,087,403 A2 and EP 2,091,666 A2 as well as in references cited therein.

After removal of the stamp 104 from the material layer 102, a formed relief material layer remains that has the relief surface 108 representing the complementary pattern 108 of the pattern 106' (Fig. 1C). This formed material layer may serve as a base for patterning a substrate layer using some etching process, or it may serve as a patterned device layer directly with or without further modification or processing.

In some printing processes the stamp is a rigid stamp that is not substantially deformable. Such stamp may for example be made of quartz.

In other printing processes, such as the SCIL process, the stamp is deformable. Such stamps may be manipulated such that a gradual contact is made with the substrate during the imprint process by temporary deformation of the stamp during the contacting step of the process. In such case the stamp 104A illustrated would have a conformable relief portion comprising a rubber or elastomeric or other deformable polymer material. A particularly advantageous example of such deformable polymer comprises or consists of polysiloxane based polymer. Often, but not necessarily, the relief portion is carried by (e.g. adhered to) a relatively rigid but deformable support portion in the form of e.g. a (thin) glass plate (not separately shown in Fig. 1A,1B and 1C). This helps improve the manipulation of the stamp 104A by the stamp holder (also referred to as the stamp manipulator) 104B.

In some embodiments, the stamp holder may comprise a groove plate for example in the form of a glass plate with one or more grooves. The groove plate is rigid and comprises at least one groove but preferably a plurality of grooves 105 in which a pressure of a gas can be controlled to manipulate the stamp. For example, an underpressure (compared to environmental pressure) can be applied so that the stamp (by its support portion if the stamp includes such portion) may be pulled to or held securely by the groove plate. Conversely, release of the stamp may be induced by increasing the pressure to environmental pressure or even overpressure. While only a limited number of system components is shown for clarity a detailed description of how such systems may be designed and used to perform such imprint methods have been described in: WO03099463A2 METHOD AND DEVICE FOR TRANSFERRING A PATTERN FROM A STAMP TO A SUBSTRATE; WO2008068701A2 METHOD AND APPARATUS FOR APPLYING A SHEET TO A SUBSTRATE; WO2008087573A2 METHOD AND SYSTEM FOR CONTACTING OF A FLEXIBLE SHEET AND A SUBSTRATE; WO2016045961A1 TRANSFER METHOD AND APPARATUS AND COMPUTER PROGRAM PRODUCT (and references cited in each of these publications), each of which is incorporated by reference in its entirety herein.

In general, in devices having multiple stacked device layers, the pattern of one device layer needs to be laterally aligned (where laterally means within the X-Y plane) with that of one or more other such layers or the base substrate. For example, successive layers of a semiconductor substrate 100 must be correctly aligned with each other for a resulting to device to function. After all, if layers are not correctly aligned then signals will not be transmitted between the layers and the device will not function correctly. Hence, during application of a new device layer an alignment step is also performed.

In the exemplary process as described here above, this means that the alignment step must be performed before the stamp 104 is brought into contact with the material layer 102 (e.g. the situation as represented in Fig. 1A), since when they are in contact lateral repositioning of the substrate 100 and stamp 104 is difficult or impossible, or could result in dragging or unwanted deformation of the material layer 102, or result in stamp damage.

For the alignment, the substrate comprises one or more substrate markers 103 and the stamp 104A, e.g., as part of the conformable portion, also comprises one or more stamp markers 105. For correct alignment of stamp with the substrate, and any underlying patterned layers of the stamp, the marker of the stamp and the marker on the substrate should be correctly aligned. The stamp and the substrate should be aligned within the X-Y plane to within a predetermined margin.

The present disclosure relates to improved approaches for aligning the stamp with the substrate. The following description provides a descriptive understanding of embodiments features of which may be interchanged and/or combined.

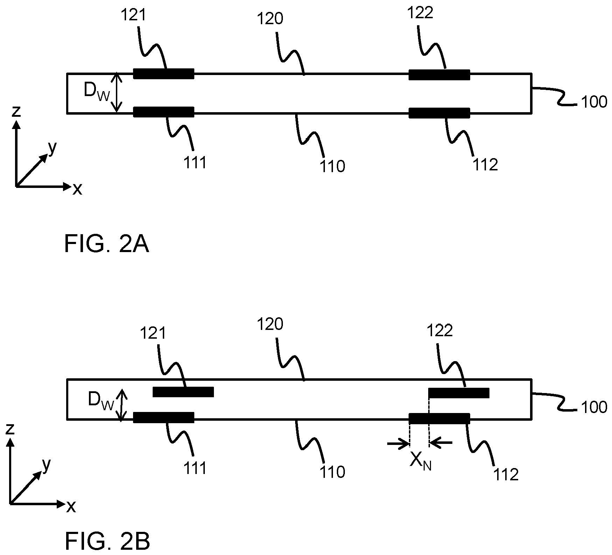

The method of the present invention uses a calibration substrate 100 as depicted in Fig. 2A. The calibration substrate 100 is formed from a material with a refractive index n which is substantially transparent to the light used in the detection of markers. The calibration substrate has first markers 111, 112 on a first surface 110 of the calibration substrate and second markers 121, 122 on a second surface 120 of the substrate. There is therefore a known predetermined displacement, Dw, between the first markers and the second markers in the Z direction. Each first marker 111 and 112 has a corresponding second marker in close proximity (in the X-Y plane) thereby forming a pair of markers. In the example of Fig. 2A the first marker and the corresponding second marker are at the same lateral position i.e. in the X-Y plane. However, in some examples, the first and second marker may have a predetermined lateral displacement from each other in the X-Y plane.

An alternative calibration substrate is depicted in Fig. 2B and this calibration substrate has first markers 111 and second markers 121 with a small predetermined lateral (i.e. in the X-Y plane) displacement, $X_N$, from each other. Additionally, the first markers are within the calibration substrate 100 rather than on the substrate surface. However, the displacement, Dw, between the first and second markers in a Z direction is known.

The calibration substrate may form an integral part of the lithographic apparatus or it may be removable. It may have means for removable attachment to the apparatus. Such means can comprise clamps, clips and/or screws or the like.

Each of the first and second markers may be either a reflective marker, for example a chrome marker, or a diffraction marker, for example a grating structure.

The method 200 as disclosed herein comprises using or providing 210 a calibration substrate 100 resting on its first surface 110 and illuminating 220 a pair of markers 111, 121 with light for example from a light source.

A light source 310 illuminates the calibration substrate 100 with a light beam at a non-perpendicular angle, γ. In this example both the first marker 111 and the second marker 121 are illuminated simultaneously. This is not necessary per se and alternatively or additionally they could be illuminated at different times. In either case the illumination is such that from the light redirected by the markers the markers may be identified. Thus, the first marker redirects the light towards a detector 320 and in this example shown the second marker redirects light towards the same detector. Different detectors may be used, but having one detector may be advantageous in view of space limitation and/or cost and/or accuracy.

The detector 320 has an optical axis and detects light along the optical axis. The optical axis, along which light is detected forms a detection angle, α, with the normal of the substrate. Thus light travelling at an angle α towards the detector will be detected. Based on the redirected light from the first and second markers the relative lateral positions (in the X-Y plane) of the first and second markers can be detected and the lateral displacement between the first and second markers determined. From the detected lateral displacement between the first and second marker the detection angle, α, can be determined 240. The detection angle is the angle of detection relative to the normal of the substrate.

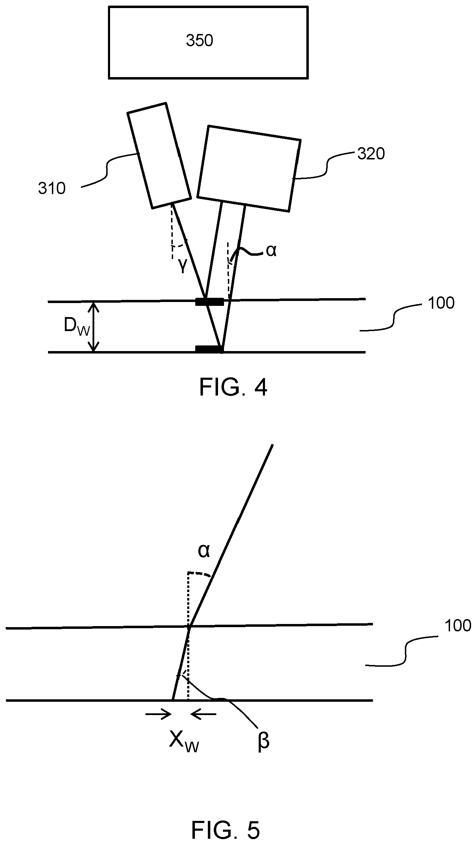

Fig. 5 is an enlarged depiction of the light redirected from the first marker 111 of calibration substrate 100. For simplicity the corresponding second marker and also the light after redirection (reflection or diffraction) are not depicted in Fig. 5. As can be seen, the light changes path at the boundary between the air and the calibration substrate 100 with a refractive index n. The angle of detection angle is α and the angle of reflection, β, is less than α because the refractive index of the calibration substrate is greater than that of air.

The lateral shift (in an X-Y plane) between between the vertical position of the second marker 121 (in this example, the second surface 120) and the vertical position of the first marker 111 (in this example, the first surface 110) due to the non-perpendicular illumination of the marker is given by $X_w$ which can be calculated as:

$$X_w = D_W \, \tan \beta = D_W \, \frac{\sin \alpha}{n} \, \frac{1}{\sqrt{1 - \frac{\sin^2 \alpha}{n^2}}}$$

where $D_w$ is the vertical distance between the first marker 111 and the second marker 121. For small angles $\frac{\sin^2 \alpha}{n^2}$ is nearly 1 and can be neglected. The detection angle, α is therefore:

$$\alpha = \sin^{-1} \frac{n * X_W}{D_W}$$

This assumes that the first marker 111 and the second marker 121 are at the same lateral (i.e. X-Y) location. If there is a displacement between the first and second marker the detection angle can be calculated as:

$$\alpha = \sin^{-1} \frac{n * (X_W - X_N)}{D_W}$$

Where $X_N$ (as depicted in Fig 2B) is the predetermined lateral displacement between the second and first marker.

In order to improve the accuracy of detection the calibration substrate 100 may be turned to rest on its second surface 120 and the process repeated. Namely, the pair of markers are illuminated by the light source 310 and detected by the detector 320. Based on the detected, redirected light the lateral displacement is detected and a second detection angle $\alpha_2$ determined. An average between the first detection angle of and the second detection angle of may be taken.

There may be several pairs of markers on the calibration substrate 100 and the same process repeated for each pair of markers. Each pair of markers may have the same lateral displacement $X_N$ and vertical displacement $D_W$ or alternatively different pairs of markers may have different lateral displacements and/or different vertical displacements from each other. If there are eight pairs of markers on a calibration substrate and each pair of markers is detected with the substrate resting on its first surface and resting on its second surface there would be a total of 16 detected detection. The average detection angle could be determined.

Once an detection angle has been determined it can be used as part of the alignment process. After all the detection angle is representative of the orientation of the detector. For example, a stamp marker on a stamp may be detected using the same detector 320 (in an unchanged position or in other words a calibrated position). Using the determined angle of detection, and knowing the vertical position of the stamp marker, the lateral position of the stamp marker can be accurately determined relative to any other marker at any other given vertical position.

The determined detection angle may also be used in a similar way to determine the lateral position of a substrate marker on a second substrate. As an example, there may be a distance of 20-300 microns between the upper surface of the second substrate and the lower surface of the stamp. The substrate marker may be illuminated and the redirected light detected. Using the determined detection angle, and knowing the vertical position of the substrate marker, the lateral position of the substrate marker can be accurately determined.

The position of the stamp marker and the position of the substrate marker, both determined using the determined detection angle, can be compared to detect alignment of the stamp and the second substrate prior to the stamp being imprinted onto the second substrate. If the substrate and stamp are aligned to within a predetermined level of accuracy, imprinting may proceed. However, if they are not aligned with a sufficient degree of accuracy (for example to within 5% of the feature size) the stamp and/or substrate may be moved to correct any misalignment.

In some examples the camera, or detector, is intended to detect at a predetermined detection angle. In these examples, the determined detection angle can be compared to the predetermined detection. If necessary the angle, or position, of the camera (or detector) can be changed. The new detection angle could then be again determined and once again compared to the predetermined detection.

An alternative application for this invention is to check that the detection angle is stable over a prolonged period. For example, the detection angle may be checked after a predetermined period. This prevents apparatus from become progressively less accurate.

Determining the detection angle, as described above, can be completed once prior to printing substrates. Additionally, or alternatively, it may be completed after n substrates have been completed. For example, the detection angle may be determined, or checked, after every 100 substrates have been printed.

The calibration process of determining the detection angle may be automated or may be performed manually. A marker at a first position on the z axis may be detected using pattern recognition. As the relative lateral position of the corresponding second marker is known the second marker can then be detected.

For each pair of markers, the following equations can be written:

$$X_n = Ax + Sx_n ; \quad Y_n = Ay + Sy_n$$

While $X_n$ and $Y_n$ are the measured shifts, n indicates the plurality of measurements (in this example sixteen), $Ax$ and $Ay$ represent the parallax errors and $Sx_n$ and $Sy_n$ are the pre-known correct shifts of the wafer. In total we get 16 equations for X with the unknown variable $Ax$. And we have 16 equations for Y with the unknown variable $Ay$. This is a system of linear equations which is solved with a linear least square fit. In this way we can calculate the parallax errors $Ax$ and $Ay$.

The present invention may also comprise a processing system 350 communicatively coupled to the light source 310 and light detector 320 and configured to determine a detection angle based on a detected lateral displacement between the first marker 111 and the second marker 121 on the calibration substrate 100.

The processing system 350 may additionally be configured to control the alignment system to illuminate a pair of markers and detect, by the light detector 320, light redirected by the first marker and the second marker.

The processing system 350 of the alignment system may be configured to control the operation of the lighting system 400 and/or the light sensor 300 to control the alignment system in performing the defined functions.

The invention may also be embodied in a computer program comprising computer program code means which is adapted, when executed by the alignment system described above, to implement the method as described above.

Fig. 7 illustrates an example of a computer 70 within which one or more parts of an embodiment may be employed. Various operations discussed above may utilize the capabilities of the computer 70. For example, one or more parts of a system for providing a subject-specific user interface may be incorporated in any element, module, application, and/or component discussed herein. In this regard, it is to be understood that system functional blocks can run on a single computer or may be distributed over several computers and locations (e.g. connected via internet), such as a cloud-based computing infrastructure.

The computer 70 includes, but is not limited to, PCs, workstations, laptops, PDAs, palm devices, servers, storages, and the like. Generally, in terms of hardware architecture, the computer 70 may include one or more processors 71, memory 72, and one or more I/O devices 73 that are communicatively coupled via a local interface (not shown). The local interface can be, for example but not limited to, one or more buses or other wired or wireless connections, as is known in the art. The local interface may have additional elements, such as controllers, buffers (caches), drivers, repeaters, and receivers, to enable communications. Further, the local interface may include address, control, and/or data connections to enable appropriate communications among the aforementioned components.

The processor 71 is a hardware device for executing software that can be stored in the memory 72. The processor 71 can be virtually any custom made or commercially available processor, a central processing unit (CPU), a digital signal processor (DSP), or an auxiliary processor among several processors associated with the computer 70, and the processor 71 may be a semiconductor based microprocessor (in the form of a microchip) or a microprocessor.

The memory 72 can include any one or combination of volatile memory elements (e.g., random access memory (RAM), such as dynamic random access memory (DRAM), static random access memory (SRAM), etc.) and non-volatile memory elements (e.g., ROM, erasable programmable read only memory (EPROM), electronically erasable programmable read only memory (EEPROM), programmable read only memory (PROM), tape, compact disc read only memory (CD-ROM), disk, diskette, cartridge, cassette or the like, etc.). Moreover, the memory 72 may incorporate electronic, magnetic, optical, and/or other types of storage media. Note that the memory 72 can have a distributed architecture, where various components are situated remote from one another, but can be accessed by the processor 71.

The software in the memory 72 may include one or more separate programs, each of which comprises an ordered listing of executable instructions for implementing logical functions. The software in the memory 72 includes a suitable operating system (O/S) 74, compiler 76, source code 75, and one or more applications 77 in accordance with exemplary embodiments. As illustrated, the application 77 comprises numerous functional components for implementing the features and operations of the exemplary embodiments. The application 77 of the computer 70 may represent various applications, computational units, logic, functional units, processes, operations, virtual entities, and/or modules in accordance with exemplary embodiments, but the application 77 is not meant to be a limitation.

The operating system 74 controls the execution of other computer programs, and provides scheduling, input-output control, file and data management, memory management, and communication control and related services. It is contemplated by the inventors that the application 77 for implementing exemplary embodiments may be applicable on all commercially available operating systems.

Application 77 may be a source program, executable program (object code), script, or any other entity comprising a set of instructions to be performed. When a source program, then the program is usually translated via a compiler (such as the compiler 76), assembler, interpreter, or the like, which may or may not be included within the memory 72, so as to operate properly in connection with the O/S 74. Furthermore, the application 77 can be written as an object oriented programming language, which has classes of data and methods, or a procedure programming language, which has routines, subroutines, and/or functions, for example but not limited to, C, C++, C#, Pascal, BASIC, API calls, HTML, XHTML, XML, ASP scripts, JavaScript, FORTRAN, COBOL, Perl, Java, ADA, NET, and the like.

The I/O devices 73 may include input devices such as, for example but not limited to, a mouse, keyboard, scanner, microphone, camera, etc. Furthermore, the I/O devices 73 may also include output devices, for example but not limited to a printer, display, etc. Finally, the I/O devices 73 may further include devices that communicate both inputs and outputs, for instance but not limited to, a NIC or modulator/demodulator (for accessing remote devices, other files, devices, systems, or a network), a radio frequency (RF) or other transceiver, a telephonic interface, a bridge, a router, etc. The I/O devices 73 also include components for communicating over various networks, such as the Internet or intranet.

If the computer 70 is a PC, workstation, intelligent device or the like, the software in the memory 72 may further include a basic input output system (BIOS) (omitted for simplicity). The BIOS is a set of essential software routines that initialize and test hardware at startup, start the O/S 74, and support the transfer of data among the hardware devices. The BIOS is stored in some type of read-only-memory, such as ROM, PROM, EPROM, EEPROM or the like, so that the BIOS can be executed when the computer 70 is activated.

When the computer 70 is in operation, the processor 71 is configured to execute software stored within the memory 72, to communicate data to and from the memory 72, and to generally control operations of the computer 70 pursuant to the software. The application 77 and the O/S 74 are read, in whole or in part, by the processor 71, perhaps buffered within the processor 71, and then executed.

When the application 77 is implemented in software it should be noted that the application 77 can be stored on virtually any computer readable medium for use by or in connection with any computer related system or method. In the context of this document, a computer readable medium may be an electronic, magnetic, optical, or other physical device or means that can contain or store a computer program for use by or in connection with a computer related system or method.

The application 77 can be embodied in any computer-readable medium for use by or in connection with an instruction execution system, apparatus, or device, such as a computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the instruction execution system, apparatus, or device. The computer readable medium can be, for example but not limited to, an electronic, magnetic, optical, electromagnetic, infrared, or semiconductor system, apparatus, device, or propagation medium.

The proposed image capture and/or processing methods, may be implemented in hardware or software, or a mixture of both (for example, as firmware running on a hardware device). To the extent that an embodiment is implemented partly or wholly in software, the functional steps illustrated in the process flowcharts may be performed by suitably programmed physical computing devices, such as one or more central processing units (CPUs) or graphics processing units (GPUs). Each process - and its individual component steps as illustrated in the flowcharts - may be performed by the same or different computing devices. According to embodiments, a computer-readable storage medium stores a computer program comprising computer program code configured to cause one or more physical computing devices to carry out an encoding or decoding method as described above when the program is run on the one or more physical computing devices.

Storage media may include volatile and non-volatile computer memory such as RAM, PROM, EPROM, and EEPROM, optical discs (like CD, DVD, BD), magnetic storage media (like hard discs and tapes). Various storage media may be fixed within a computing device or may be transportable, such that the one or more programs stored thereon can be loaded into a processor.

To the extent that an embodiment is implemented partly or wholly in hardware, the blocks shown in the block diagrams of Figs. 1 and 5 may be separate physical components, or logical subdivisions of single physical components, or may be all implemented in an integrated manner in one physical component. The functions of one block shown in the drawings may be divided between multiple components in an implementation, or the functions of multiple blocks shown in the drawings may be combined in single components in an implementation. Hardware components suitable for use in embodiments of the present invention include, but are not limited to, conventional microprocessors, application specific integrated circuits (ASICs), and field-programmable gate arrays (FPGAs). One or more blocks may be implemented as a combination of dedicated hardware to perform some functions and one or more programmed microprocessors and associated circuitry to perform other functions.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. If a computer program is discussed above, it may be stored/distributed on a suitable medium, such as an optical storage medium or a solid-state medium supplied together with or as part of other hardware, but may also be distributed in other forms, such as via the Internet or other wired or wireless telecommunication systems. If the term "adapted to" is used in the claims or description, it is noted the term "adapted to" is intended to be equivalent to the term "configured to". Any reference signs in the claims should not be construed as limiting the scope.

The flowchart and block diagrams in the Figures illustrate the architecture, functionality, and operation of possible implementations of systems, methods, and computer program products according to various embodiments of the present invention. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

**Claims**

1. A method of determining a detection angle in a lithographic apparatus, the method comprising:

    using a calibration substrate having a refractive index n and having a first pair of markers, the pair of markers having a predetermined lateral displacement from each other, the first marker in the pair of markers being at a first predetermined vertical position within the calibration substrate and the second marker in the pair of markers being at a second predetermined vertical position within the calibration substrate, the calibration substrate resting on its first surface;
    illuminating the pair of markers by a light source;
    detecting, by a detector having an optical axis, light redirected from the first marker and the second marker to determine a first detected lateral displacement between the first marker and the second marker, wherein the optical axis of the detector is at a detection angle, $\alpha_1$, relative to the normal of the substrate of less than 90°; and
    determining the first detection angle based on the first detected lateral displacement between the first and second marker.

2. The method according to claim 1, further comprising:

    turning the calibration substrate to rest on its second, different, surface;
    illuminating the pair of markers by the light source;
    detecting light redirected from the first marker and the second marker to determine a second detected lateral displacement between the first marker and the second marker;
    determining a second detection angle, $\alpha_2$, based on the second detected lateral displacement between the first and second marker.

3. A method according to claim 2 further comprising determining a detection angle by determining an average of the first detection angle and the second detection angle.

4. The method according to any one of the preceding claims, wherein the first marker is a contrast marker configured to reflect a portion of the light to the light sensor.

5. The method according to claim 1 or 2, wherein the second marker is a contrast marker configured to reflect a portion of the light to the light sensor.

6. The method according to any one of the preceding claims wherein the predetermined lateral displacement between the first marker and the second marker is zero.

7. The method according to any one of the preceding claims wherein the first marker is on the first substrate surface and the second marker is on the second substrate surface.

8. The method according to any one of the preceding claims wherein the first detection angle, $\alpha_1$ is given by:

$$\alpha_1 = \sin^{-1} \frac{n * (X_1 - LD)}{D_W}$$

where $X_1$ is the measured displacement, LD is the lateral displacement and Dw is the vertical distance between the first marker and the second marker.

9. The method according to any one of claims 2 to 6 wherein the second detection angle, $\alpha_2$ is given by:

$$\alpha_2 = \sin^{-1} \frac{n * (X_2 - LD)}{D_W}$$

where $X_2$ is the measured displacement, LD is the lateral displacement and Dw is the vertical distance between the first marker and the second marker.

10. The method according to any one of the preceding claims further comprising:

    using a stamp comprising a stamp marker;
    illuminating the stamp marker using the light source;
    detecting the light from the light source redirected by the stamp marker;
    determining the lateral position of the stamp marker using at least the first detected detection angle.

11. The method according to any one of the preceding claims further comprising:

using a second substrate comprising a substrate marker;

illuminating the substrate marker using the light source;

detecting the light from the light source redirected by the substrate marker;

determining the lateral position of the substrate marker using at least the first detected detection angle.

12. An alignment system for determining an alignment between a stamp and a substrate in a substrate conformal imprint lithography process, wherein the alignment system comprises:

a light source;

a light sensor having an optical axis and configured to detect light from the light source redirected by the substrate wherein the optical axis of the light sensor is at a detection angle, $\alpha_1$, relative to the normal of the substrate of less than 90 °;

a processing system communicatively coupled to the light source and light sensor and configured to determine a first detection angle, $\alpha_1$, based on the first detected lateral displacement between the first and second marker on a calibration substrate.

13. A system according to claim 12 wherein the processing is further configured to control the alignment system to carry out the following steps:

illuminate a pair of markers by the light source;

detect light redirected from a first marker and a second marker to determine a first detected lateral displacement between the first marker and the second marker.

14. A system according to either claim 12 or claim 13 further comprising a calibration substrate, the calibration substrate having a refractive index n and a first pair of markers, the pair of markers having a predetermined lateral displacement from each other, the first marker in the pair of markers being at a first predetermined vertical position within the calibration substrate and the second marker in the pair of markers being at a second predetermined vertical position within the calibration substrate having a first marker.

15. A computer program product comprising computer program code means which, when executed by the alignment system of claim 13, causes the alignment system to perform all of the steps of the method according to any of claims 1 to 12.

FIG. 1A

FIG. 1B

FIG. 1C

121    120    122

$D_W$                    100

111    110    112

z
y
x

FIG. 2A

121    120    122

$D_W$                    100

111    110    $X_N$    112

z
y
x

FIG. 2B

200

Load a calibration substrate — 210

Illuminate pair of markers — 220

Detect redirected light — 230

Determine first detected angle of illumination — 240

FIG. 3

FIG. 4

FIG. 5

FIG. 6

Europäisches
Patentamt

European
Patent Office

Office européen
des brevets

# EUROPEAN SEARCH REPORT

Application Number

EP 22 21 4517

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/085161 A1 (SMEETS ERIK M J [NL] ET AL) 20 April 2006 (2006-04-20) | 1,4,5,11 | INV. G03F7/00 |
| A | * abstract *<br>* figures 1-5 *<br>* paragraphs [0002], [0007], [0009], [0014], [0043] - [0047], [0054] * | 2,3, 6-10, 12-15 | |
| X | US 2013/015597 A1 (HATTORI TADASHI [JP]) 17 January 2013 (2013-01-17) | 12,13,15 | |
| A | * abstract *<br>* figures 1-5 *<br>* paragraphs [0002], [0024] - [0033] * | 1-11,14 | |

TECHNICAL FIELDS
SEARCHED      (IPC)

G03F

The present search report has been drawn up for all claims

| Place of search | Date of completion of the search | Examiner |
|---|---|---|
| Munich | 24 May 2023 | Andersen, Ole |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

......................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 21 4517

This annex lists the patent family members relating to the patent documents cited in the above-mentioned European search report.
The members are as contained in the European Patent Office EDP file on
The European Patent Office is in no way liable for these particulars which are merely given for the purpose of information.

24-05-2023

| Patent document cited in search report | | Publication date | Patent family member(s) | | Publication date |
|---|---|---|---|---|---|
| US 2006085161 | A1 | 20-04-2006 | JP | 4264434 B2 | 20-05-2009 |
| | | | JP | 2006114916 A | 27-04-2006 |
| | | | US | 2006085161 A1 | 20-04-2006 |
| US 2013015597 | A1 | 17-01-2013 | JP | 5864929 B2 | 17-02-2016 |
| | | | JP | 2013026288 A | 04-02-2013 |
| | | | KR | 20130009630 A | 23-01-2013 |
| | | | TW | 201302419 A | 16-01-2013 |
| | | | US | 2013015597 A1 | 17-01-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3126909 A
- EP 2087403 A2
- EP 2091666 A2
- WO 03099463 A2
- WO 2008068701 A2
- WO 2008087573 A2
- WO 2016045961 A1